# EUROPEAN PATENT APPLICATION

(11) **EP 2 284 893 A2**
(43) Date of publication of application: **16.02.2011**
(21) Application number: 10182924.0
(22) Date of filing: 08.04.2005
(51) Int. Cl.: H01L 27/142, H01L 31/048

(54) **Photovoltaic module with an electronic device**

(30) Priority: 09.04.2004 US 560958 P
(62) Divisional of application: 05734143.0
(71) Applicant: BP Corporation North America Inc., Warrenville, IL 60555 (US)
(72) Inventor: Posbic, Jean P., Frederick, MD 21701 (US); Amin, Dinesh, Clarksburg, MD 20871 (US)
(74) Representative: Hamer, Christopher K.

(57) **Abstract**

A photovoltaic module (1) comprising a first substrate (5), a backing sheet (10), a solar cell (20) or a plurality of solar cells, each solar cell positioned between the substrate and the backing sheet, at least one thin electrically conducting board (40) positioned between the substrate (5) and the backing sheet (10) and preferably where the module has at least one electronic device, preferably positioned on the electrically conducting board (40), that provides the module with a desired function or capability.

## Description

This application claims the benefit of U.S Provisional Patent Application 60/560,958 filed on April 9, 2004.

### Field of the Invention

The present invention relates to photovoltaic modules and methods for their manufacture. More particularly, the present invention relates to photovoltaic modules containing solar cells wherein a thin, electrically conducting board is contained within the module. This invention also relates to a photovoltaic module wherein the module also contains, in addition to the solar cells, one or more electronic devices preferably positioned between a substrate sheet and backing sheet that form the module, and wherein the electronic device provides the module with one or more enhanced functions or operating capabilities.

### Background of the Invention

Photovoltaic devices convert light energy, particularly solar energy, into electrical energy. Photovoltaically generated electrical energy can be used for all the same purposes of electricity generated by batteries or electricity obtained from established electrical power grids, but is a renewable form of electrical energy. One type of photovoltaic device is known as a photovoltaic module or also referred to as a solar module. These modules contain one or, more typically and preferably, a plurality of photovoltaic cells or solar cells positioned between a substrate sheet, such as a sheet of clear glass or clear polymeric material, and a backing sheet, such as a polymeric material, a sheet of metal or another sheet of glass. The solar cells can be made from wafers of silicon or other suitable semiconductor material, or they can be a thin film type of cell typically deposited on the substrate or backing sheet by the various processes and methods known to those of skill in the art of manufacturing photovoltaic devices. One of the more common types of photovoltaic modules contains a plurality of individual solar cells made from silicon wafers. Such individual solar cells are typically made of either monocrystalline or multi-crystalline silicon wafers and, typically, a number of such individual cells are electrically linked in a desired arrangement to achieve a module having a desired electrical output upon exposure to the sun.

Those skilled in the art of manufacturing photovoltaic modules are continually striving to improve the efficiency and durability of such modules, and they are continually striving to reduce the manufacturing costs of photovoltaic modules. Since photovoltaic modules by their nature need to be exposed to the sun, they are necessarily either on the outside of a structure, such as building wall or roof, or otherwise incorporated into a building or positioned on some other supporting structure so that they are exposed to sunlight. Photovoltaic modules therefore form part of the outward appearance of a building or other structure they are mounted on or made part of. Thus, there is a need to make photovoltaic modules aesthetically appealing. While progress is being made in reducing the manufacturing costs of and increasing the efficiency of photovoltaic modules, purchasing and installing photovoltaic modules nevertheless usually involves a significant capital investment. Due to their value, installed photovoltaic modules are susceptible to theft. Replacement costs, which include the cost of the module itself and the cost of the repair work to replace the module, are typically high. Also, due to the cost of replacing photovoltaic modules, they must be manufactured so they resist premature failure.

Photovoltaic modules having one or more enhanced functions would also be desirable for the user of the module; such as a function that automatically records the performance of the module for later retrieval or for transmission of the data to central location for processing, or a function that prevents the module from being operated if the module is disconnected from service without proper authorization, such as from theft.

The art therefore needs a photovoltaic module that is easily manufactured. The art needs a photovoltaic module that is protected from failure and from theft. The art needs photovoltaic modules, having enhanced functions. The art needs a photovoltaic module that can provide these and other features and is aesthetically appealing. The present invention provides such photovoltaic modules.

### Summary of the Invention

This invention is a photovoltaic module comprising a first substrate, a backing sheet, a solar cell or a plurality of solar cells, each solar cell positioned between the substrate and the backing sheet, and at least one thin electrically conducting board positioned between the substrate and the backing sheet.

This invention is also a photovoltaic module comprising a first substrate sheet, a backing sheet, a solar cell or a plurality of solar cells, each positioned between the substrate and the backing sheet, and at least one device, preferably an electronic device, that provides the module with an enhanced function or operating capability. Preferably the device that provides enhanced function is positioned between the substrate sheet and the backing sheet and sealed within the module.

This invention is also a method for manufacturing such photovoltaic modules.

The photovoltaic modules of this invention are useful for converting sunlight into electrical energy.

### Brief Description of the Figures

Figure 1 is drawing of one embodiment of the photovoltaic module of this invention comprising a thin, electrically conducting board.
Figure 2 is a plan view drawing of one embodiment of this invention of the thin, electrically conducting board.
Figure 3 is side view drawing of the thin electrically conducting board in Figure 2.
Figure 4 is a drawing of one embodiment of an electrically conducting board used in the photovoltaic modules of this invention having an enhanced function device included within the module.
Figure 5 is a side view drawing of the electrically conducting board shown in Figure 4.

### Detailed Description of the Invention

In one aspect, this invention is a photovoltaic module comprising a thin, electrically conducting board contained within the module and a process for manufacturing such a module. This invention is also a photovoltaic module comprising a thin, electrically conducting board and one or more electronic devices contained within the module that provides the photovoltaic module with one or more enhanced functions or enhanced operating capabilities.

The invention will now be described in detail with respect to embodiments of the invention comprising a photovoltaic module comprising a plurality of individual silicon wafer-type solar cells and one or more by-pass diodes that protect the module from damage when one or more cells in the module are shaded from exposure to sunlight. However, it is to be understood that the modules of this invention can be any type of photovoltaic module such as a thin film photovoltaic module where one or more solar cells are formed on a substrate sheet or a backing sheet.

In the majority of applications for generating electrical energy from photovoltaic modules, a plurality of photovoltaic modules are arranged in an array or collection and positioned on a roof or other structure. In such an array a plurality of photovoltaic modules are usually connected in a series arrangement to achieve a desired voltage from the array. Within each photovoltaic module a number of, and typically all of, the individual solar cells are also usually connected in series. For example, each module may contain 1 to more than 100 individual solar cells. Thus, in such arrangement, each solar cell in the array is in series with a large number of other solar cells, and each cell is generating electrical current when the array is exposed to sunlight. In such an arrangement, one or more of the cells in a module may become shaded. For example, blowing debris, such as leaves or branches from a nearby tree, can settle on a module shading one of more solar cells from exposure to the sun. Ice or snow can also cause such shading. In some instances, a bird or other animal can rest on-the module causing such shading of one or more solar cells. When such individual cell in a module is so shaded, it can become reversed biased. If the debris or other cause of the shading is not removed, the reversed biased cell will generally overheat and such cell, and the module it is within, can be damaged or possibly destroyed.

The art, however, has developed a suitable preventative method to deal with the relatively common event of such shading and its potentially catastrophic results. In such preventative method, the module is provided with one or more by-pass diodes. The by-pass or shunt diode can be connected across rows of series-connected solar cells and in parallel therewith. When there is no shading, and all solar cells are converting solar energy into electrical current, the by-pass diode is in a reversed biased state and the flow of electrical current is through the solar cell circuit. When current flow through any of the cells in the circuit is substantially reduced, such as when it becomes reversed biased due to shading, the parallel-connected, by-pass diode becomes forward biased and the current flow, which would otherwise damage or destroy the shaded solar cell and module it is within, is through the forward biased by-pass diode and around the circuit containing the shaded cell. When the shading is removed, and the solar cell or cells that were shaded begin to generate the proper amount of electric current and are again forward biased, the by-pass diode returns to its reversed biased state. In such a manner the by-pass diode protects the shaded solar cell from damage or destruction.

In prior photovoltaic modules, such by-pass diodes were either flitted and sealed onto the back of the module, generally behind the solar cells, and included a copper metal heat spreader plate, or were mounted on a terminal block located in a larger junction box. More recently, by-pass diodes have been sandwiched within a module by using Schottky diodes that have the same thickness as the solar cells.

In one of the embodiments of the photovoltaic modules of this invention, one or more by-pass diodes, for example, 1 to about 6 or to about 8 or to about 10 diodes, preferably where one or more and preferably all are Schottky by-pass diodes, are attached to or mounted on a thin electrically conducting board, and the board having the diode or diodes mounted thereon is sandwiched between the first substrate sheet and the backing sheet of the module. Such board is suitably about, or less than about, the thickness of the solar cells used in the module. For example, it can be about 0.1 to about 2 millimeters in thickness or, more preferably, about 0.2 to about 1 millimeter in thickness. For example, it can be about 0.5 millimeters in thickness. Although the board can be made of any electrically conducting material such as, for example, one or more conducting metals such as copper, tin, aluminum, silver or gold, preferably the board is a laminate made by adhering a film of a conducting metal, such as one or more of the metals mentioned above, to a suitable, preferably dielectric, substrate material such a resin or polymeric material. The polymeric material can be, for example, an epoxy reinforced with fiberglass. Such metal film can be about 0.05 millimeters to about 0.25 millimeters thick. The preferred thin conducting board useful in the module of this invention is the type of board typically used to manufacture printed circuits, or so-called PC boards.

The thin conducting board can be of any suitable dimension. However, the length of the preferred thin, electrically conducting board is preferably approximately about the width or length of the module it is placed within so that it can be easily placed between a first substrate sheet and the backing sheet of the module. It can be of any suitable width. Thus, the thin, electrically conducting board can be about 500 to about 2000 millimeters in length, for example, about 750 to about 1500 millimeters in length. The thin conducting boards can be about 10 to about 50 millimeters in width, for example about 25 millimeters in width.

There can be one or more such boards in the module where each board is the same or different. They can be located anywhere within the module. Preferably, however, they are positioned within the module along the side or along the end of the module and preferably next to or near to the edge of the module.

The conducting board can have one or more, for example, 2 to about 10, separate electrically conducting regions on the board. Such regions can be in the form of strips. If the board is of the type where a film of conducting metal is laminated onto a suitable non-conducting substrate, such as a non-conducting polymer or resin, the metal film can be in the form of one or more, for example, 2 to about 10, separate electrically conducting regions, such as strips, on the non-conducting substrate. In such a manner the thin conducting board can be used, as will be discussed in more detail below, in the form of a desired electrical circuit.

The thin electrically conducting board can, as mentioned above, be used to mount one or more suitable by-pass diodes. For example, it can be used to mount thin, Schottky-type, by-pass diodes. As will be discussed below, such board can be used to mount other devices, preferably other electronic devices. The board can also be marked with or otherwise contain information such as serial numbers, product numbers, addresses, module performance information, bar codes and the like, or different information. It can also be marked with or otherwise contain indicia such as a company logo or other designs. Thus, in addition to functioning as an electrically conducting board, the thin, electrically conducting board in the photovoltaic modules of this invention serves as a medium for displaying information and designs. When mounted in the module as described hereinabove, such information or designs can be seen through the first substrate sheet.

The thin electrically conducting board can be and preferably is manufactured of materials and installed in the photovoltaic module so that it forms an aesthetically appealing strip or banner in the module visible through the first substrate plate. Such strip or banner is particularly aesthetically appealing when it has on its surface the logo or other design as mentioned above.

This aspect of the invention will now be described with reference to the figures, which show certain embodiments of the invention but are not meant in any way to limit the scope thereof.

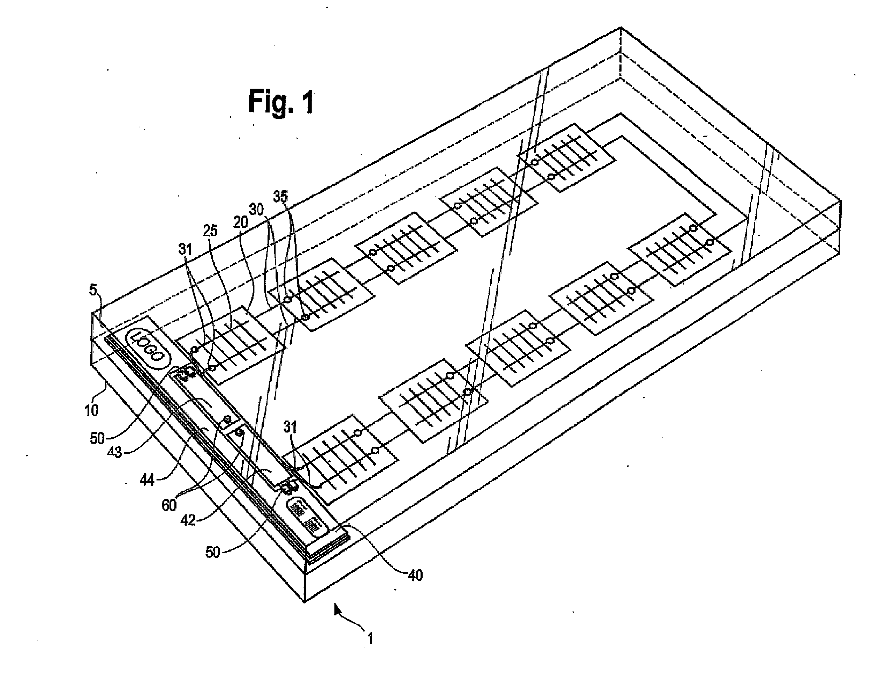

Figure 1 shows one embodiment of the photovoltaic module 1 of this invention. The photovoltaic module in Figure 1 has a first substrate sheet 5 preferably made of glass or other suitable transparent material, and backing sheet 10. Backing sheet can be made of any suitable material that, preferably, can be used to form a waterproof and moisture proof seal with the first substrate sheet. For example, the backing sheet can be made of glass or it can be made of one or more polymeric materials such as a polyester material. The backing sheet can be made of Tedlar. Between first substrate sheet 5 and backing sheet 10 is sandwiched a plurality of solar cells 20 electrically connected in series. Between the first substrate sheet and the backing sheet is also a sheet of ethylene vinyl acetate (EVA) or other suitable sealing material that seals the first substrate sheet to the backing sheet with the solar cells sealed therebetween. For clarity, in Figure 1, only one solar cell is designated by a number 20. These solar cells can be any type of solar cell such as cells made from multi-crystalline or mono-crystalline silicon wafers. Each cell, as shown in the figure, has a grid-type, front electrical contact 25. (For clarity, only one grid-type front contact is labeled in the figure.) Sunlight enters through first substrate sheet 5 and impinges on front side of solar cells 20. Cells 20 are electrically connected in series by wires 30. Wires 30 are attached to the back contact on the back side of solar cells 20 (back side of solar cells not shown) and to solder contact points 35 on front side of solar cells 20 to form the series connected cells. (For clarity, only one set of wires 30 and one set of solder contact points 35 on front side of solar cells are labeled in the figure.) The wires are suitably flat, tinned-copper leads, electrical wires or other suitable electrical conduits. Module 1 also comprises thin, electrically conducting board 40 about 0.5 millimeters thick, about 25 millimeters wide and about 560 millimeters long and made of a resin or polymeric material and having laminated thereon a thin layer of copper metal (about 0.15 millimeters thick) in three electrically conducting sections or strips shown as 42, 43 and 44. The sections or strips 42, 43 and 44 thus form three different and unconnected electrical conduits. Spacing between the three sections or strips can be about 1 to about 2 millimeters. Positioned between sections 43 and 44, and between sections 42 and 44, are by-pass diodes 50 One terminal of the diode is electrically connected to one strip and the other terminal of the diode is electrically connected to the other strip, as shown in the figure. Solder can be used to make the electrical connections. Preferably, such diodes have a thin profile. Preferably they are no greater in thickness than the thickness of the solar cells. Preferably they are Schottky-type diodes. For example, they can be type SBM 1040 (10 amp forward current and 40 volt peak inverse voltage.) Each of sections 42 and 43 have solder points 60 which can be used to connect the module to the array or other system or electrical device that uses the electrical energy generated by the photovoltaic module. Typically, electrical wires or leads connected to such solder points protrude out the back of the module through holes in backing sheet 10. A suitable potting material can be used to seal such holes on the backing sheet. Electrical leads 31 connect the series-connected solar cells to the strips 42 and 43 as shown in the figure.

As shown in Figure 1, the by-pass diodes are electrically connected to sections 42 and 44, and to sections 43 and 44 of the electrically conducting board 40. These diodes are normally in a reverse biased state when the solar cells in the solar cell circuit are all functioning normally in their forward biased state generating electrical current from solar radiation. However, if one or more of the solar cells in the solar cell circuit become reversed biased, for example, due to shading, the by-pass diodes will become forward biased and form an electrically conducting circuit that is in parallel to the circuit formed by the solar cells. The circuit comprising the forward biased by-pass diodes will allow the electrical current that would otherwise pass through the circuit of electrically-connected solar cells in the Photovoltaic module to by-pass the solar cell circuit and prevent damage to the shaded, reverse biased solar cell or cells. When such shading is removed, the affected cell will revert to its forward biased state and the module will once again function as a generator of electrical energy.

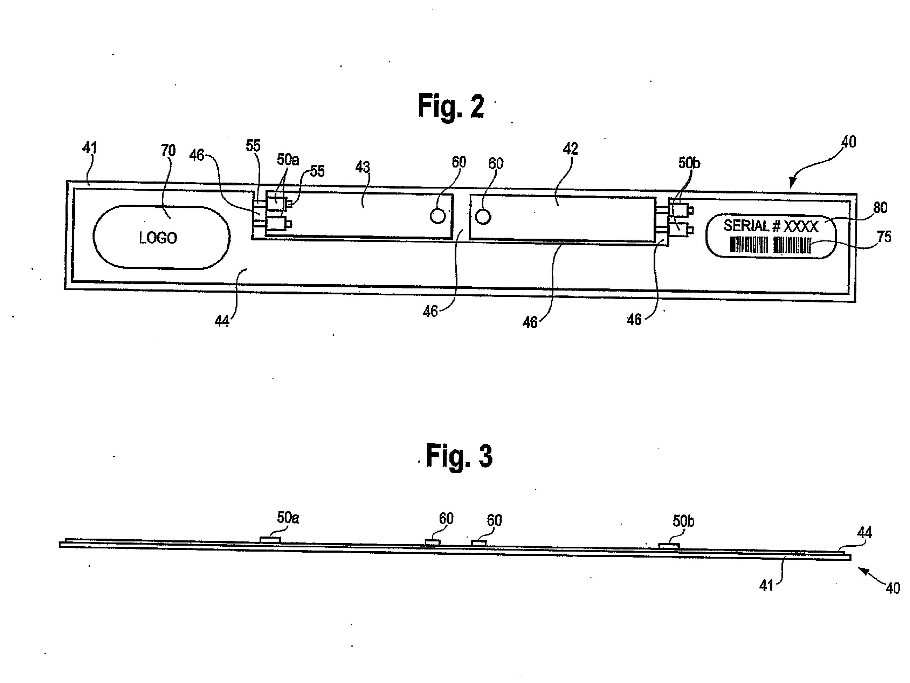

Figure 2 shows a thin conducting board 40 in more detail. Figure 2 is a plan view while Figure 3 is side view of thin conducting board 40. Components of thin conducting board 40 shown in Figure 1 are numbered the same in Figures 2 and 3. Figure 2 shows in more detail the gaps or space 46 between electrically conducting sections 42, 43 and 44. Figure 3 shows in more detail how the electrically conducting strips 42, 43 and 44 are thin (i.e., thin gauge) metal strips laminated on resin or polymer board 41. Figure 2 also shows in more detail the by-pass diodes 50. As shown in Figure 2, by-pass diodes 50 can be two sets of diodes where each set has two diodes. Diodes 50a are electrically connected to electrically conducting sections 44 and 43, while diodes 50b are electrically connected to electrically conducting sections 42 and 44. Electrical connections from the diode to the electrically conducting board can be made by solder points 55. (For clarity, only one set of solder points 55 is labeled in Figure 2).

As shown in Figure 3, electrically conducting board 40 has a low or thin side profile even with diodes 50 and solder points 60 attached. As stated above, the overall thickness of the board, including the diodes, is preferably no more than about the thickness of the solar cells used in the module. For example, the overall thickness of the board and the diode attached thereto can be about 0.5 to about 2.0 millimeters in thickness.

As also shown in Figure 2, thin, electrically conducting board 40 may have printed, scribed, etched, or labeled thereon, or otherwise deposited or formed thereon, a logo 70, bar code 75 or serial number 80. While only a logo, bar code and serial number is exemplified in Figure 2, it is to be understood, as set forth hereinabove, that the thin electrically conducting board of this invention can have any design, lettering, numbering or other indicia deposited or formed thereon. Thus, the thin, electrically conducting board is both an aesthetically appealing and functional part of the photovoltaic module of this invention. It can serve as a mounting structure to mount electrical devices such as one or more by-pass diodes, and it can serve as a medium for displaying logos, designs, or other information. Additionally, because the electrically conducting board of this invention can be as thin as or thinner than the solar cells in the module, it does not contribute to the overall thickness of the module. Since it is laminated within the module it,is protected from weather elements, from moisture or other sources of damage. Because it can be laminated within the module, it does not create an unappealing bulge on the back of the module. In addition to serving as a substrate for the attachment of the by-pass diode, the electrically conducting board of this invention also serves to distribute and dissipate heat that is generated by the diode.

As mentioned above, due to its ability to conduct electricity, and particularly where the board extends across most or all of the width or length of the module, it can be used as a bus bar to make electrical connections to the solar cells within the module. As shown in Figure 1, the electrical wires or leads 31 from the solar cell circuit are connected to the electrical conducting board. The use of such a board in the module also provides for a convenient way to align the individual solar cells within the module.

While Figure 1 shows the thin, electrically conducting board having the side with the electrically conducting strips 42, 43 and 44, the solder points 60, and by-pass diodes 50 facing the light receiving side of the photovoltaic module, it is to be understood that it is not necessary for the board to be placed in the module in this manner. The board can be placed within the module so that such side is facing the other way. In such an arrangement, the logo, design, indicia information such as, for example, serial numbers, product information, bar code, etc, would be added to the side opposite to the side of the board having the electrically conducting strips 42, 43 and 44, solder points 60 and by-pass diodes 50, so such information can be viewed through the transparent first substrate sheet 5. Although not shown in Figure 1, photovoltaic module 1 can also have a frame surrounding or partially surrounding the module. Such frame can be used to mount the module where desired.

Although one aspect of this invention has been described above in detail with respect to the use of an electrically conducting board to support and electrically connect one or more by-pass diodes for the photovoltaic module, in another aspect of the photovoltaic modules of this invention such modules can contain, with or without such electrically conducting board, one or more other devices, preferably one or more electronic chips or electronic devices other than a solar cell or by-pass diode that provides the photovoltaic modules with an enhanced function or enhanced operating capability. For example, the module can contain an electrical output converter, preferably a solid state device, to provide for altering the voltage of the photovoltaic module, i.e., a so-called direct current (DC) to DC converter for stepping up or stepping down the output voltage of the module or a DC to alternating current (AC) converter for converting the DC current from the photovoltaic module to AC current. These converters, preferably a specifically designed integrated circuit (IC) module or an Application Specific Integrated Circuit (ASIC), can be placed between the DC collecting wires of the photovoltaic module and, for example, an AC load. If a thin electrically conducting board is included with the photovoltaic module, such electrical output converter can be physically located on the thin electrical conducting board. The module can contain a radio frequency identification chip (RF ID chip). Such chip can be used to readily identify the module without having to resort to other data. Such chip can preferably be a Texas instruments Tag-it™ RI-116-112A RF ID chip that allows product identification and authentication. The module can contain a memory chip that stores, for example, operating or other data that can be retrieved after a period of data accumulation. It can contain an anti-theft chip. Such anti-theft device can be an electronic chip that is activated when the module is, without authorization, disconnected from the electrical circuit it is part of, so that the chip will stop the electrical current that would otherwise be generated by the module. Such device will deter theft of the module. The devices that provide the photovoltaic module with an enhanced function or enhanced operating capability, such as the output converters for altering the voltage or current of the module, a memory chip, the RF ID chip, or the anti-theft chip can be mounted on the electrically conducting board as described herein if, for example, the module has such an electrically conducting board. One or more of such devices can also be mounted on or in the module, preferably in a location between the substrate sheet and backing sheet. If required for operation such device can be electrically connected to the electrical output of the photovoltaic module. The module can contain a battery, located between the first substrate sheet and the backing sheet or outside the module, where the battery can be connected to one or more of the electrical devices or chips so that they remain activated when the photovoltaic module is not generating electrical current and where the battery can be maintained in the charge-state by being electrically connected to the electrical output of the photovoltaic module.

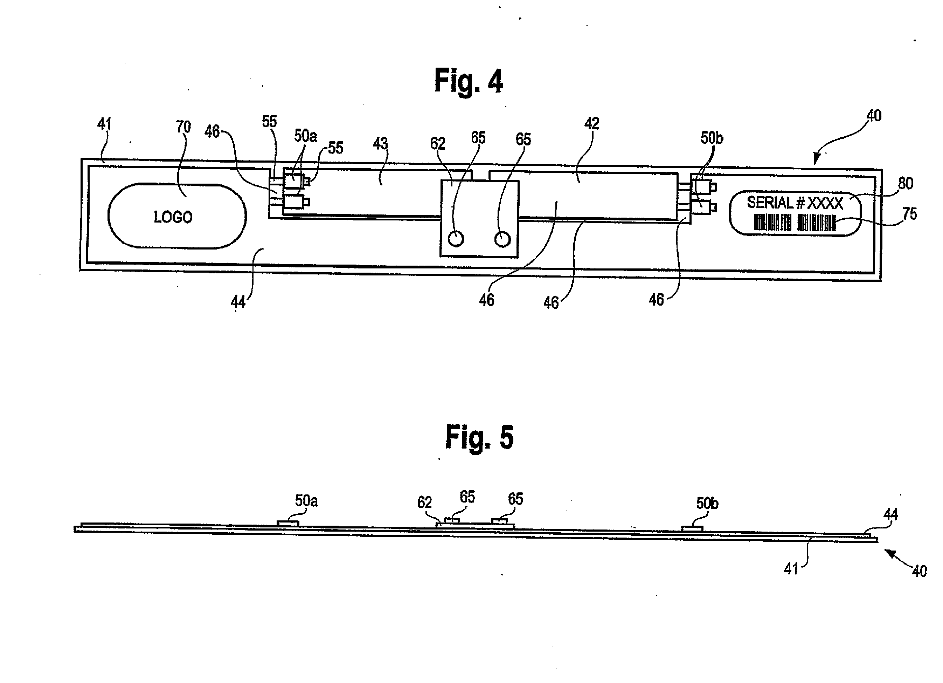

Figures 4 and 5 show additional embodiments of this invention but are not intended to limit the scope of the invention.

Figure 4 shows how the electrically conducting board of this invention can be used to mount an output converter for altering the electrical output of the photovoltaic module. Figure 4 shows the same thin electrically conducting board as shown in Figure 2 except that Figure 4 has output converter (for example, it can be a DC to DC converter or a DC to AC converter) 62 positioned on the thin electrically conducting board 40. Elements that are numbered the same in Figures 2 and 4 are the same elements. As shown in Figure 4, output converter 62 has electrical output solder points 65. Output converter 62 is placed on the thin electrically conduction board 40 such that solder points 60 on the board 40 are electrically connected to the electrical inputs of converter 62. Such connection is not shown in the figure. Thus, electrical output of the photovoltaic module at points 60 enters output converter 62, output converter 62 alters the electrical output of the photovoltaic module in the desired fashion, and the altered electrical output is available at output solder points 65.

Figure 5 is a side view of the thin electrically conducting board shown in Figure 4. Components of the thin electrically conducting board shown in Figure 4 are numbered the same as in Figure 5. As shown in Figure 5, electrical output converter 62 preferably has a thin profile so it can fit between, for example, a substrate sheet and a backing sheet of a photovoltaic module without forming a bulge. Preferably the electrical output converter, as well as any other device that provides the photovoltaic module with an enhanced function or enhanced operating capability in accordance with this invention, is as thin as or thinner than the solar cells in the module. For example, less than about 2 millimeters in thickness. If the device is mounted on a thin conducting board in accordance with this invention, the thickness of the board and the devices is preferably as thin as or thinner than the solar cells in the module.

The thin electrically conducting board shown in Figures 4 and 5 can be mounted within a photovoltaic module as shown in Figure 1. However, as described herein, the photovoltaic modules of this invention having a device that provides for enhanced function or enhanced operating capabilities does not have to have the thin electrically conducting board. The device can be suitably mounted on the module or, preferably, between the substrate and backing sheets and electrically connected, if necessary, to the solar cell circuit to provide for the desired enhanced function or operating capability. Such connections can be made by appropriate electrical wiring or other electrical conductors.

Although Figures 4 and 5 show a device for altering the electrical output of the module, it is to be understood that one or more additional devices or one or more different devices, such as one or more of the devices described herein, can be so mounted on the thin electrically conducting board or mounted in some other fashion on or preferably within the photovoltaic module to achieve the desired purpose of the device as would be readily apparent to one of skill in the art. As used herein the term or similarly used term "device that provides the photovoltaic module with an enhanced function or enhanced operating capability" does not include by-pass diodes.

Although the invention has been described with respect to photovoltaic modules containing solar cells made from silicon wafers, it is to be understood that the invention is not limited to such solar cells. The solar cells can be of any type. For example, they can be thin film-type solar cells such as thin film amorphous silicon cells or CdS/CdTe cells. Such solar cells are known in the art and can be deposited onto a suitable substrate material such as glass or metal by known methods. For example, methods for forming amorphous silicon cells which can be used in this invention are set forth in U.S. Patent Nos. 4,064,521 and 4,292,092, UK Patent Application 9916531.8 (Publication No. 2339963, February 9, 2000) all of which are incorporated herein by reference.

The use of one or more devices that provide the photovoltaic module with an enhanced function or enhanced operating capability has been described herein with respect to a photovoltaic, module containing one or more solar cells. The photovoltaic module has been described as having a substrate sheet and a backing sheet. However, this invention is not limited to that specific type of photovoltaic device. It is to be understood that this invention includes any photovoltaic device that has one or more devices, such as the devices described herein, that provides the photovoltaic device with an enhanced function or enhanced operating capability. For example, this invention is also a photovoltaic device comprising at least one solar cell and at least one device, preferably an electronic device such as a chip or an electrical output converter, wherein the electronic- device provides the photovoltaic device with an enhanced function or enhanced operating capability.

This invention is also a process of making a photovoltaic module comprising sealing between a first substrate sheet and a backing sheet at least one solar cell and preferably a plurality of electrically connected solar cells, at least one electronic device such as, for example, a by-pass diode, or an electrical device that provides the photovoltaic module with an enhanced function or an enhanced operating capability as described herein above, and, optionally, and at least one thin, electrically conducting board, and wherein the board optionally contains mounted thereon the electronic device. The process preferably comprises sealing the solar cells, the electronic device that provides for the enhanced function or enhanced operating capability and, optionally, the electrically conducting board, between the substrate sheet and the backing sheet. The sealant is preferably one or more polymeric materials such as a sheet of ethylene vinyl acetate. During the sealing process, the sealant material can be heated to a temperature where it softens or melts and can then form a good seal between the substrate sheet and the backing sheet. In a typical procedure the substrate sheet, the solar cells, the enhanced function device and, optionally, the electrically conducting board, are arranged in a sandwich type of arrangement with a sheet of sealant material placed between the sheets and the entire sandwich arrangement is placed in an apparatus that heats and presses the sandwich together under a suitable vacuum to eliminate any air bubbles that may otherwise form.

It is to be understood that only certain embodiments of the invention have been described and set forth herein. Alternative embodiments and various modifications will be apparent from the above description to those of skill in the art. These and other alternatives are considered equivalents and within the spirit and scope of the invention.

### Example

A 125 Watt nominal photovoltaic module was made with 36 multi-crystalline cells (each cell measuring 157 millimeters x 157 millimeters) connected in series and a laminated board with 4 Schottky by-pass diodes, BP Solar logo and bar-code label. The PC board used was made of FR4 material with a temperature rating of at least 145°C and meeting UL rating 94V-0. The board surface and all conductors in the modules did not contain lead.

U.S Provisional Patent Application 60/560,958 filed on April 9, 2004, is incorporated herein by reference in its entirety.

The present application also contains the following clauses:
1. A photovoltaic module comprising:
   a first substrate sheet,
   a backing sheet,
   a solar cell or a plurality of solar cells, each positioned between the substrate and the backing sheet,
   at least one thin electrically conducting board positioned between the substrate and the backing sheet in electrical connection with at least one of the solar cells.
2. The photovoltaic module of clause 1 wherein the board comprises at least two separate electrically conducting regions.
3. The photovoltaic module of clause 2 wherein the separate electrically conduction regions are in the form of strips.
4. The photovoltaic module of clause 3 wherein the board comprises a laminate of one or more conducting metals and one or more of a resin or polymeric material.
5. The photovoltaic module of clause 4 wherein the polymeric material comprises an epoxy resin and fiberglass.
6. The photovoltaic module of clause 1 further comprising one or more electronic devices mounted on the board.
7. The photovoltaic module of clause 1 further comprising one or more by-pass diodes mounted on the board.
8. The photovoltaic module of clause 2 further comprising a by-pass diode having two electrical poles where the by-pass diode is positioned on the electrically conducting board between two of the conducting regions so that one electrical pole of the diode is electrically connected to one conducting region and the other electrical pole of the diode is electrically connected to the other conducting region.
9. A photovoltaic module comprising:
   a first substrate sheet,
   a backing sheet,
   a plurality of solar cells electrically connected in series arrangement and being positioned between the first substrate sheet and the backing sheet and having a first solar cell and a last solar cell in such series arrangement,
   at least one thin electrically conducting board positioned between the first substrate sheet and the backing sheet and comprising at least first and second electrically separated and electrically conducting regions,
   at least one by-pass diode having a first electrical pole and a second electrical pole of opposite polarity to the first electrical pole and positioned such that the first pole is electrically connected to the first conducting region and the second pole is connected to the second electrically conducting region, and
   electrical leads electrically connecting the first solar cell in the series of solar cells to the first electrically conducting region and electrical leads electrically connecting the last solar cell the series of solar cells to the second electrically conducting region.
10. A photovoltaic module comprising:
   a first substrate sheet,
   a backing sheet,
   a solar cell or a plurality of solar cells, each positioned between the substrate and the backing sheet, and
   at least one electronic device that provides the module with an enhanced function or enhanced operating capability.
11. The photovoltaic module of clause 10 wherein the electronic device is an electronic device selected from one or more of a memory chip, an anti-theft chip, an RF ID chip, a DC to AC converter, a battery, and a DC to DC converter.
12. The photovoltaic module of clause 10 wherein the electronic device is positioned between the substrate and the backing sheet.
13. A process for making a photovoltaic module comprising sealing between a first substrate sheet and a backing sheet at least one solar cell and at least one thin, electrically conducting board, and wherein the board optionally contains mounted thereon at least one electronic device that provides the photovoltaic module with an enhanced function or an enhanced operating capability.
14. The process of clause 13 wherein the electronic device is one or more of a memory chip, an anti-theft chip, an RF ID chip, a DC to AC converter, a battery, a DC to DC converter.
15. A process for making a photovoltaic module comprising sealing between a first substrate sheet and a backing sheet at least one solar cell and at least one device that provides the photovoltaic module with an enhanced function or an enhanced operating capability.
16. The process of clause 15 wherein the device is one or more of a memory chip, an anti-theft chip, an RF ID chip, a DC to AC converter, a battery, a DC to DC converter.
17. A process for making a photovoltaic module comprising sealing between a first substrate sheet and a backing sheet at least one solar cell and at least one thin, electrically conducting board, and wherein the board contains mounted thereon at least one by-pass diode.
18. A photovoltaic device comprising at least one solar cell and at least one electronic device wherein the electronic device provides the photovoltaic device with an enhanced function or enhanced operating capability.
19. The photovoltaic device of clause 18 wherein the electronic device is one or more of a memory chip, an anti-theft chip, an RF ID chip, a DC to AC converter, a battery, a DC to DC converter.

## Claims

1. A photovoltaic module comprising:
a first substrate sheet,
a backing sheet,
a solar cell or a plurality of solar cells, each positioned between the substrate and the backing sheet, and
at least one electronic device that provides the module with an enhanced function or enhanced operating capability.

2. The photovoltaic module of Claim 1 wherein the electronic device is an electronic device selected from one or more of a memory chip, an anti-theft chip, an RF ID chip, a DC to AC converter, a battery, and a DC to DC converter.

3. The photovoltaic module of Claim 1 wherein the electronic device is positioned between the substrate and the backing sheet.

4. A process for making a photovoltaic module comprising sealing between a first substrate sheet and a backing sheet at least one solar cell and at least one thin, electrically conducting board, and wherein the board optionally contains mounted thereon at least one electronic device that provides the photovoltaic module with an enhanced function or an enhanced operating capability.

5. The process of Claim 4 wherein the electronic device is one or more of a memory chip, an anti-theft chip, an RF ID chip, a DC to AC converter, a battery, a DC to DC converter.

6. A process for making a photovoltaic module comprising sealing between a first substrate sheet and a backing sheet at least one solar cell and at least one device that provides the photovoltaic module with an enhanced function or an enhanced operating capability.

7. The process of Claim 6 wherein the device is one or more of a memory chip, an anti-theft chip, an RF ID chip, a DC to AC converter, a battery, a DC to DC converter.

8. A photovoltaic device comprising at least one solar cell and at least one electronic device wherein the electronic device provides the photovoltaic device with an enhanced function or enhanced operating capability.

9. The photovoltaic device of Claim 8 wherein the electronic device is one or more of a memory chip, an anti-theft chip, an RF ID chip, a DC to AC converter, a battery, a DC to DC converter.
